# EUROPEAN PATENT APPLICATION

(11) **EP 2 657 954 A1**
(43) Date of publication of application: **30.10.2013**
(21) Application number: 10860925.6
(22) Date of filing: 20.12.2010
(51) Int. Cl.: H01L 21/00, H01L 31/00, H01L 51/00

(54) **ORGANIC SEMICONDUCTOR MATERIALS, PREPARATION METHODS AND APPLICATIONS THEREOF**

(71) Applicant: Ocean's King Lighting Science&Technology Co., Ltd., Guangdong 518054 (CN)
(72) Inventor: ZHOU, Mingjie, Shenzhen, Guangdong 518054 (CN); HUANG, Jie, Shenzhen, Guangdong 518054 (CN); LIU, Hui, Shenzhen, Guangdong 518054 (CN)
(74) Representative: Michalski Hüttermann & Partner Patentanwälte
(86) International application number: PCT/CN2010/079981
(87) International publication number: WO 2012/083510

(57) **Abstract**

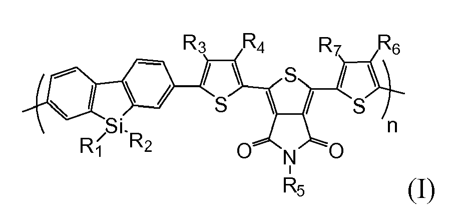

Disclosed are organic semiconductor material having the general formula(I), Wherein R₁, R₂, R₃, R₄, R₅, R₆ and R₇ are C₁-C₂₀ alkyl, n is an integer greater than 1 and less than or equal to 100. The preparation methods and application of said organic semiconductor materials are also disclosed. Said organic semiconductor materials possess improved stability and photoelectric conversion efficiency.

## Description

### FIELD OF THE INVENTION

The present invention relates to an organic semiconductor material, and more particularly relates to an organic semiconductor material containing units of silafluorene and thienyl - thiophene pyrrole-diketone. The present invention also relates to preparation methods and applications of the organic semiconductor materials.

### BACKGROUND OF THE INVENTION

The world economy today is built on the basis of fossil fuels, such as coal, oil and natural gas. However, these non-renewable fossil energies are constantly depleting. Since the beginning of the 21 st century, the global energy problems and the consequent problems of environmental pollution and climate warming have become more and more apparent and gradually intensify. Because of the outstanding advantages of solar energy, such as having universal and wide distribution, a vast number of resources, pollution-free, clean, safe and easy to get and so on, it is considered to be one of the most promising renewable sources. Solar cell converts solar energy into electrical energy directly, so it is a practical and effective way of using solar energy. However, currently commercialized solar cells are still limited to the silicon-based inorganic solar cell and so on, but their price is too expensive, which beyonds the current widely acceptable levels, and this greatly limits the scope of their use. In order to reduce the cost of battery and expand the range of applications, people have been looking for a new type of solar cell material for a long time.

Organic solar cell is a new type of solar cell, compared with the inorganic semiconductor material which has disadvantages of sources limited, expensive, toxic, complicated preparation process, the cost is too high and so on, the organic solar cell has some advantages that the inorganic solar cell can't compare with, such as extensive source, structural diversity and regulating capability, low cost, safe and environmental protection, the production process is simple, light, large area flexible preparation etc., it can be widely used in a variety of areas of the building, lighting and generate electricity, which has an important development and application prospects. Therefore, many domestic and foreign research institutions and enterprises have given considerable attention and investment. However, so far, the photoelectric conversion efficiency of the organic solar battery is much lower than inorganic solar battery. Therefore, the development of new organic semiconductor materials for improving the efficiency of the organic solar cell is very important.

### SUMMARY OF THE INVENTION

According to the above problems, one object of the present invention is to provide a kind of organic semiconductor material containing units of silafluorene and thienyl - thiophene pyrrole-diketone.

Another object is to provide a preparation method and applications of the organic semiconductor material as well.

An organic semiconductor material is provided according to the present invention, which represented by the following general formula (I):

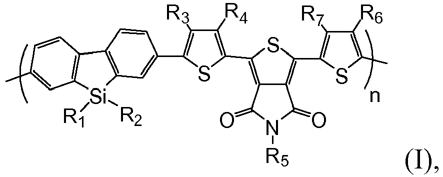

Where: R₁, R₂, R₃, R₄, R₅, R₆ and R₇ are identical or different C₁-C₂₀ alkyl, n is an integer equal to or greater than 1 and less than or equal to 100, preferably n is an integer equal to or greater than 20 and less than or equal to 80.

A preparation method of the organic semiconductor material, including the steps of:

Step S1, dissolving 2, 7 - dibromo-9, 9 - dialkyl silafluorene and n-butyl lithium in a first solvent at a temperature from -100°C to -25°C according to a molar ratio of 1:2.0 to 1.0:4.0, and then adding 2 - isopropoxy-4, 4, 5, 5 - tetramethyl-1, 3, 2 - dioxaborolane, reacting for 24 to 48 hours to obtain 2, 7 - bis (4, 4, 5, 5 - tetramethyl -1, 3, 2 - dioxaborolan-yl) - 9, 9 - dialkyl silafluorene;

Step S2, dissolving 1,3 - bis (3,4 - dialkyl thiophen-2 - yl)-5 - alkyl-4H-thieno [3, 4-c] pyrrole -4,6 (5H) - diketone and a brominating agent in a second solvent at a temperature from 0°C to 30°C according to a molar ratio of 1:2 to 1:3, reacting for 12 to 48 hours to obtain 1,3 - bis (5 - bromo-3,4 - dialkyl thiophen-2 - yl)-5 - alkyl-4H-thieno [3, 4-c] pyrrole -4,6 (5H) - diketone; and

Step S3, under an oxygen-free environment, adding the 2, 7 - bis (4, 4, 5, 5 - tetramethyl-1, 3,2 - dioxaborolan-yl) - 9,9 - dialkyl silafluorene prepared in the step S1 and the 1,3 - bis (5 - bromo-3,4 - dialkyl thiophen-2 - yl)-5 - alkyl-4H-thieno [3, 4-c] pyrrole -4,6 (5H) - diketone prepared in the step S2 in a third solvent containing catalyst and alkali solution according to a molar ratio of 1:*a*, then performing Suzuki reaction for 24 to 72 hours at a temperature from 65°C to 120°C to obtain the organic semiconductor material; wherein *a* is equal to or greater than 0.95 and less than or equal to 1.05.

The organic semiconductor material above can be widely used in fields of organic solar cells, organic field-effect transistors, organic electroluminescent devices, organic optical memories, organic non-linear devices or organic laser devices.

Compared with the prior art, the main advantages of the present invention are:

1, the synthetic routes of silafluorene-based monomers and thiophene - thiophene pyrrole diketones monomer are relatively simple and mature. It is easy to improve the solubility and the molecular weight of the product by introducing alkyl, and to achieve spin-coating polymer or spin-coating oligomers;

2, silafluorene-based monomer has a good light stability and thermal stability, it is an extremely excellent donor material, thiophene - thiophene pyrrole diketones monomer is an extremely excellent receptor material, the polymer which is composed of silafluorene-based monomer and thiophene - thiophene pyrrole diketones can form a strong donor - acceptor structure, on the one hand it can improve the stability of the material, on the other hand it is conducive to reduce the bandgap of material, thereby expanding the range of absorbing sunlight, and improving the photoelectric conversion efficiency;

3, suzuki reaction is a very mature polymerization reaction with a high yield, mild conditions and easy control.

### BRIEF DESCRIPTION OF THE DRAWINGS

FIG. 1 is a schematic structure view of an organic solar cell device using the organic semiconductor materials of the example 5 according to the present invention as an activity layer ;

FIG. 2 is an I-V curve of an organic solar cell device using the organic semiconductor materials of the example 5 according to the present invention as an activity layer;

FIG. 3 is a schematic structure view of an organic electroluminescent device using the organic semiconductor materials of the example 6 according to the present invention as an activity layer;

FIG. 4 is a schematic structure view of an organic field-effect transistor using the organic semiconductor materials of the example 7 according to the present invention as an activity layer.

### DETAILED DESCRIPTION OF THE EMBODIMENTS

An organic semiconductor material containing units of silafluorene and thienyl - thiophene pyrrole-diketone is provided, which is represented by the following formula (I):

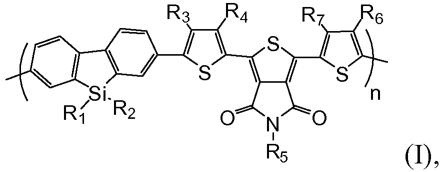

Where: R₁, R₂, R₃, R₄, R₅, R₆ and R₇ are identical or different C₁-C₂₀ alkyl, preferably R₁ and R₂ are identical C₁-C₂₀ alkyl, or R₃ and R₄ are identical C₁-C₂₀ alkyl, or R₆ and R₇ are identical C₁-C₂₀ alkyl, n is an integer equal to or greater than 1 and less than or equal to 100, preferably n is an integer equal to or greater than 20 and less than or equal to 80.

Preparation methods of the organic semiconductor material are also provided including the steps of:

In step S1, 2, 7 - dibromo-9, 9 - dialkyl silafluorene (A₁) and n-butyl lithium (n-BuLi) are added in a first solvent at a temperature from -100°C to -25°C according to a molar ratio of 1:2 to 1:4 , and then 2 - isopropoxy-4, 4, 5, 5 - tetramethyl-1, 3, 2 - dioxaborolane (C₁) or bis (pinacolato) diboron having the structural formula of 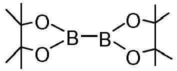 is added, then the reaction is continued for 24 to 48 hours to obtain the product, i.e. 2, 7 - bis (4, 4, 5, 5 - tetramethyl-1, 3, 2 - dioxaborolan -yl) - 9, 9 - dialkyl silafluorene (B₁); the first solvent is tetrahydrofuran, ether, dichloromethane, chloroform or ethyl acetate and so on, a molar amount of the C₁ is 2 to 4 times of a molar amount of the A₁, the reaction formula is as follows: 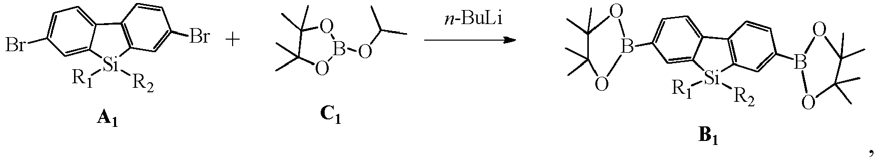 or

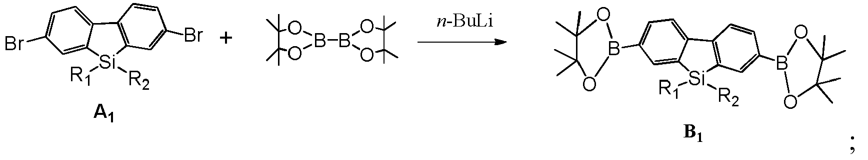

Where: R₁ and R₂ are identical or different C₁-C₂₀ alkyl;

In step S2, raw materials of thiophene - thiophene pyrrole diketone are provided, such as 1,3 - bis (3,4 - dialkyl-thiophen-2 - yl)-5 - alkyl-4H-thieno [3, 4 -c] pyrrole-4,6 (5H) - diketone (A₂) ,and a brominating agent such as N-bromosuccinimide (NBS, the same below) are added in a second solvent at a temperature from 0°C to 30°C according to a molar ratio of 1:2 to 1:4 ,then the reaction lasts for 24 to 48 hours to obtain the product, i.e.1,3 - bis (5 - bromo-3,4 - dialkyl-thiophen-2 - yl)-5 - alkyl-4H-thieno [3, 4-c] pyrrole - 4,6 (5H) - diketone(B₂); the second solvent is at least one selected from the group consisting N, N-dimethyl formamide (DMF), tetrahydrofuran (THF), ether, dichloromethane, chloroform, ethyl acetate and acetic acid, the reaction formula is as follows:

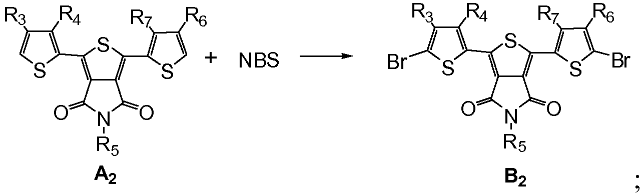

Where: R₃, R₄, R₅, R₆ and R₇ are identical or different C₁-C₂₀ alkyl;

In step S3, under an oxygen-free environment, the B₁ obtained from the step S1 and B₂ obtained from the step S2 are added in a third solvent containing catalyst and alkali solution according to a molar ratio of 1:*a*, (where 0.95≤*a*≤1.05), then a Suzuki reaction is performed for 24 to 72 hours at a temperature of 65°C to 120°C to obtain the product, i.e. the organic semiconductor materials (I), the catalyst is organic palladium catalyst or a mixture of organic palladium and organic phosphine ligand;(a molar ratio of the organic palladium to the organic phosphine ligand is 1:1 to 1:20, in the mixture), the organic palladium can be selected from the group consisting Pd(PPh₃)₄, Pd₂(dba)₃ and Pd(PPh₃)₂Cl₂, the organic phosphine ligand is P(*o*-Tol)₃, the mixture of organic palladium and organic phosphine ligand could be Pd₂(dba)₃/P(*o*-Tol)₃; a molar amount of the catalyst is 0.005 to 0.10 times of a molar amount of the 2, 7 - bis (4, 4, 5, 5 - tetramethyl-1, 3,2 - dioxaborolan -yl) - 9,9 - dialkyl silafluorene (B₁), the alkali solution is selected from the group consisting NaOH aqueous solution, Na₂CO₃ aqueous solution, NaHCO₃ aqueous solution and tetraethyl ammonium hydroxide aqueous solution, a molar amount of the alkali in the alkaline solution is 2 to 20 times of a molar amount of the 2, 7 - bis (4, 4, 5, 5 - tetramethyl-1, 3, 2 - dioxaborolan -yl) - 9, 9 - dialkyl silafluorene, the third solvent is at least one selected from the group consisting tetrahydrofuran, toluene, chloroform, and ethyl acetate; the reaction formula is as follows:

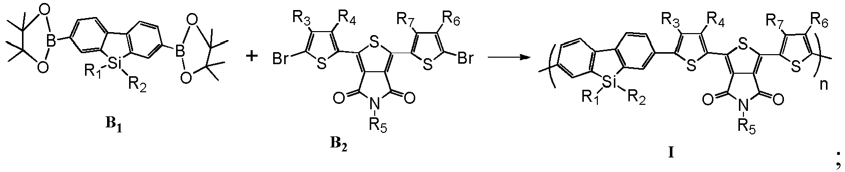

Where: n is an integer greater than 1 and less than or equal to 100, preferably n is an integer equal to or greater than 20 and less than or equal to 80.

For a better understanding of the contents of the present invention patent, the following examples and drawings are provided to further illustrate the technical solutions of the present invention, which includes material preparation and device fabrication, and it is not limited to the scope of the invention.

In this embodiment, the oxygen-free atmosphere forming the anaerobic environment is primarily nitrogen atmosphere, but it also can be other inert gas atmosphere, which is not limited in here.

EXAMPLE 1

An organic semiconductor material represented by the following general formula was disclosed in this example:

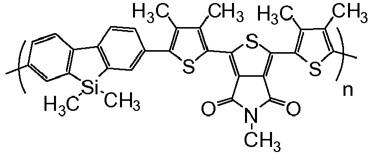

n = 20;

The preparation process of the organic semiconductor material above was described as follows:

1, the preparation of 2, 7 - bis (4, 4, 5, 5 - tetramethyl-1, 3, 2 - dioxaborolan -yl) - 9, 9 - dialky silafluorene:

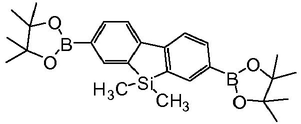

In conditions of -100°C and a nitrogen atmosphere, 40.00 mL (1.00 M) of n-butyllithium solution was added to a reaction flask containing 3.68 g of 2, 7 - dibromo-9, 9 - dimethyl silafluorene and 120 mL of tetrahydrofuran, after being stirred for 2 hours, 4.33 mL of 2 - isopropoxy-4, 4, 5, 5 - tetramethyl-1, 3, 2 - dioxaborolane was slowly added dropwise, thawed to room temperature, and then the stirring was continued for 48 hours. After the reaction was ended, the reaction mixture was poured into water, and extracted with ether, dried by anhydrous magnesium sulfate, rotary evaporated, and separated by column chromatography to obtain a solid product.

MALDI-TOF-MS (m/z): 462.3 (M⁺).

2, the preparation of 1,3 - bis (5 - bromo-3,4 - dimethyl-thiophen-2 - yl)-5 - methyl-4H-thieno [3, 4-c] pyrrole -4,6 (5H) - diketone:

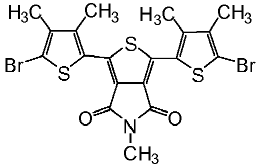

In conditions of 0°C and avoiding light, 0.36 g of NBS was added in batches to a reaction flask containing 0.39 g of 1,3 - bis (3,4 - dimethyl-thiophen-2 - yl)-5 - methyl-4H-thieno [3, 4-c] pyrrole-4,6 (5H) - diketone and 20 mL of DMF, and then the mixture was stirred for 48 hours. After the reaction was ended, the reaction mixture was poured into ice water to quench, and extracted with dichloromethane, dried by anhydrous magnesium sulfate, filtrated, rotary evaporated, and separated by column chromatography to obtain a solid product.

MALDI-TOF-MS (m/z): 545.33 (M⁺).

3, the preparation of the organic semiconductor material:

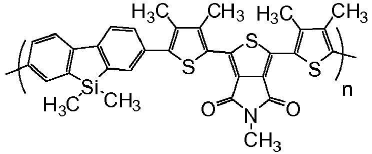

Under a nitrogen atmosphere, 7 mL 20% Wt of tetraethyl ammonium hydroxide solution and toluene (20 mL) were added to a reaction flask containing 0.462 g of 2, 7 - bis (4, 4, 5, 5 - tetramethyl-1, 3, 2 - dioxaborolan -yl) - 9,9 -dialkyl silafluorene, 0.544 g of 1,3 - bis (5 - bromo-3,4 - dimethyl-thiophen-2 - yl)-5 - methyl-4H-thieno [3, 4-c] pyrrole -4,6 (5H) - diketone and 0.082 g of Pd(PPh₃)₄. Using nitrogen to replace air for 1 hour, the mixture was heated to 65°C, then reacted for 72 hours. After the reaction was ended, the reaction mixture was deposited with methanol for three times, filtrated, and dried in vacuum to obtain a solid product.

GPC: Mn=12198, PDI=2.4.

EXAMPLE 2

An organic semiconductor material represented by the following general formula was disclosed in this example:

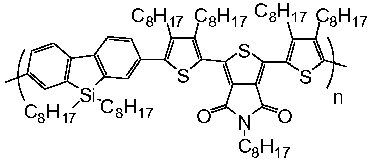

n = 43;

The preparation process of the organic semiconductor material above was described as follows:

1, the preparation of 2,7 - bis (4, 4, 5, 5 - tetramethyl-1, 3, 2 - dioxaborolan -yl) - 9, 9 -dioctyl silafluorene:

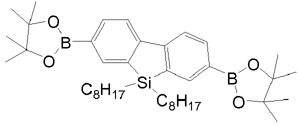

In conditions of -78°C and a nitrogen atmosphere, 10.00 mL (2.00 M) of n-butyl lithium solution was added to a two-necked flask by syringe containing 5.65 g of 2,7 - dibromo-9, 9 - dioctyl silafluorene and 100.00 mL of ether, after being stirred for 2 hours, 4.90 mL of 2 - isopropoxy-4, 4, 5, 5 - tetramethyl-1, 3, 2 -dioxaborolan was slowly added dropwise, thawed to room temperature, and then the stirring was continued for 33 hours. After the reaction was ended, the reaction mixture was poured into water, and extracted with ether, dried by anhydrous magnesium sulfate, rotary evaporated, and separated by column chromatography to obtain a solid product.

MALDI-TOF-MS (m/z): 658.6 (M⁺).

2, the preparation of 1,3 - bis (5 - bromo-3,4 - dioctyl -thiophen-2 - yl)-5 - octyl-4H-thieno [3, 4-c] pyrrole -4,6 (5H) - diketone:

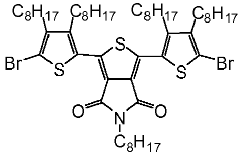

In conditions of 10°C and avoiding light, 0.42 g of NBS was added in batches to a reaction flask containing 1.04 g of 1,3 - bis (3,4 - dioctyl thiophen-2 - yl)-5 - octyl-4H-thieno [3, 4 the-c] pyrrole-4,6 (5H) - diketone and 30 mL of tetrahydrofuran, and then the mixture was stirred for 38 hours. After the reaction was ended, the reaction mixture was poured into ice water to quench, and extracted with dichloromethane, dried by anhydrous magnesium sulfate, filtrated, rotary evaporated, and separated by column chromatography to obtain a solid product.

MALDI-TOF-MS (m/z): 1036.3 (M⁺).

3, the preparation of organic semiconductor material:

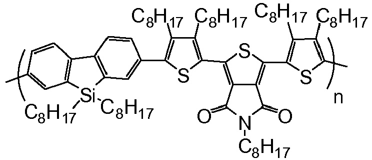

Under a protection of nitrogen atmosphere, 8 mL 20% Wt of NaHCO₃ solution and tetrahydrofuran (30 mL) were added to a reaction flask containing 0.659 g of 2, 7 - bis (4, 4, 5, 5 - tetramethyl-1, 3, 2 - dioxaborolan -yl) - 9, 9 - dioctyl silafluorene and 1.036 g of 1,3 - bis (5 - bromo-3,4 - dioctyl -thiophen-2 - yl)-5 - octyl-4H-thieno [3, 4-c] pyrrole -4,6 (5H) - diketone and 0.084 g of Pd(PPh₃)₄. Using nitrogen to replace air for 1 hour, the mixture was heated to 85°C, then reacted for 64 hours. After the reaction was ended, the reaction mixture was deposited with methanol for three times, filtrated, and dried in vacuum to obtain a solid product.

GPC: Mn=55176, PDI=2.0.

EXAMPLE 3

An organic semiconductor material represented by the following general formula was disclosed in this example:

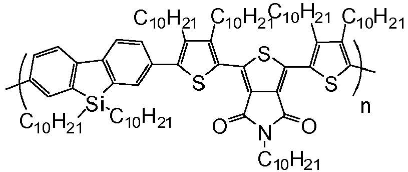

n = 80;

The preparation process of the organic semiconductor material above was described as follows:

1, the preparation of 2, 7 - bis (4, 4, 5, 5 - tetramethyl-1, 3, 2 - dioxaborolan -yl) - 9, 9 -didecyl silafluorene:

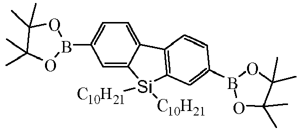

In conditions of -45°C and a nitrogen atmosphere , 25.00 mL (2.00 M) of n-butyl lithium solution was added to a two-necked flask by syringe containing 12.40 g of 2, 7 - dibromo-9, 9 - didecyl silafluorene and 200.00 mL of chloroform, after being stirred for 1 hour, 9.89 mL of 2 - isopropoxy-4, 4, 5, 5 - tetramethyl-1, 3, 2 -dioxaborolan was slowly added dropwise, thawed to room temperature, and then the stirring was continued for 26 hours. After the reaction was ended, the reaction mixture was poured into water, and extracted with ether, dried by anhydrous magnesium sulfate, rotary evaporated, and separated by column chromatography to obtain a solid product.

MALDI-TOF-MS (m/z): 714.7 (M⁺).

2, the preparation of 1,3 - bis (5 - bromo-3,4 - didecyl-thiophen-2 - yl)-5 - decyl-4H-thieno [3, 4-c] pyrrole -4,6 (5H) - diketone:

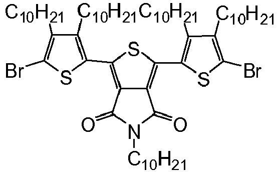

In conditions of 20°C and avoiding light, 0.55 g of NBS was added in batches to a reaction flask containing 1.02 g of 1,3 - bis (3,4 -didecyl thiophen-2 - yl)-5 - decyl -4H-thieno [3, 4 -c] pyrrole-4,6 (5H) - diketone and 30 mL of ether, and then the mixture was stirred for 24 hours. After the reaction was ended, the reaction mixture was poured into ice water to quench, and extracted with dichloromethane, dried by anhydrous magnesium sulfate, filtrated, rotary evaporated, and separated by column chromatography to obtain a solid product.

MALDI-TOF-MS (m/z): 1176.5 (M⁺).

3, the preparation of organic semiconductor material:

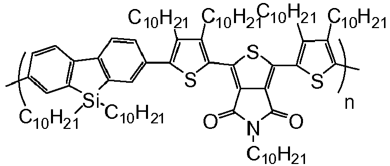

Under a protection of nitrogen atmosphere, 9 mL 2 M of NaHCO₃ solution and 0.101 g of quaternary ammonium salt 336 and chloroform (40 mL) were added to a reaction flask containing 0.715 g of 2, 7 - bis (4, 4, 5, 5 - tetramethyl-1, 3, 2 - dioxaborolan -yl) - 9,9 - dioctyl silafluorene and 1.177 g of 1,3 - bis (5 - bromo-3,4 - didecyl -thiophen-2 - yl)-5 - decyl-4H-thieno [3, 4-c] pyrrole -4,6 (5H) - diketone and 0.133 g of Pd(PPh₃)₄. Using nitrogen to replace air for 2 hours, the mixture was heated to 100°C, then reacted for 45 hours. After the reaction was ended, the reaction mixture was deposited with methanol for three times, filtrated, and dried in vacuum to obtain a solid product.

GPC: Mn =118363, PDI = 1.9.

EXAMPLE 4

An organic semiconductor material represented by the following general formula was disclosed in this example:

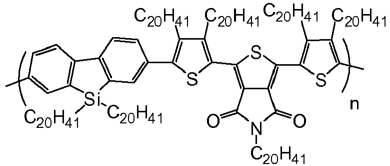

n = 100;

The preparation process of the organic semiconductor material above was described as follows:

1, the preparation of 2, 7 - bis (4, 4, 5, 5 - tetramethyl-1, 3, 2 - dioxaborolan -yl) - 9, 9 - dieicosyl silafluorene:

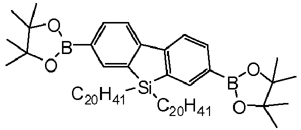

In conditions of -25°C and a nitrogen atmosphere, 10.00 mL (2.00 M) of n-butyl lithium solution was added to a reaction flask containing 9.01 g of 2, 7 - dibromo-9, 9 - dieicosyl silafluorene and 150.00 mL of tetrahydrofuran, after being stirred for 2 hours, 5.30 mL of 2 - isopropoxy-4, 4, 5, 5 - tetramethyl-1, 3, 2 -dioxaborolan was slowly added dropwise, thawed to room temperature, and the stirring was continued for 47 hours. After the reaction was ended, the reaction mixture was poured into water, and extracted with ether, dried by anhydrous magnesium sulfate, rotary evaporated, and separated by column chromatography to obtain a solid product.

MALDI-TOF-MS (m/z): 995.3 (M⁺).

2, the preparation of 1,3 - bis (5 - bromo-3,4 - dieicosyl-thiophen-2 - yl)-5 - eicosyl-4H-thieno [3, 4-c] pyrrole -4,6 (5 H) - diketone:

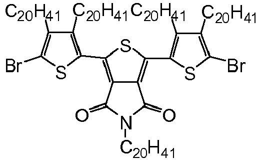

In conditions of 30 °C and avoiding light, 0.71 g of NBS was added in batches to a reaction flask containing 1.72 g of 1,3 - bis (3,4 -dieicosyl thiophen-2 - yl)-5 - eicosyl -4H-thieno [3, 4 the-c] pyrrole-4,6 (5H) - diketone and 40 mL of tetrahydrofuran, and then the mixture was stirred for 12 hours. After the reaction was ended, the reaction mixture was poured into ice water to quench, and extracted with dichloromethane, dried by anhydrous magnesium sulfate, filtrated, rotary evaporated, and separated by column chromatography to obtain a solid product.

MALDI-TOF-MS (m/z): 1877.9 (M⁺).

3, the preparation of organic semiconductor material:

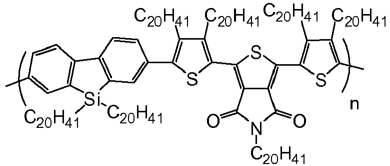

Under a protection of nitrogen atmosphere, 11 mL 20%Wt of tetraethyl ammonium hydroxide solution and toluene (40 mL) were added to a reaction flask containing 0.995 g of 2, 7 - bis (4, 4, 5, 5 - tetramethyl-1, 3, 2 - dioxaborolan -yl) - 9, 9 - dieicosyl silafluorene and 1.878 g of 1,3 - bis (5 - bromo-3,4 - dieicosyl -thiophen-2 - yl)-5 - eicosyl-4H-thieno [3, 4-c] pyrrole -4,6 (5H) - diketone and 0.112 g of Pd(PPh₃)₄ and 0.052 g P(*o*-Tol)₃. Using nitrogen to replace air for 1 hour, the mixture was heated to 120°C, then reacted for 24 hours. After the reaction was ended, the reaction mixture was deposited with methanol for three times, filtrated, and dried in vacuum to obtain a solid product.

GPC: Mn=246140, PDI=1.7.

EXAMPLE 5

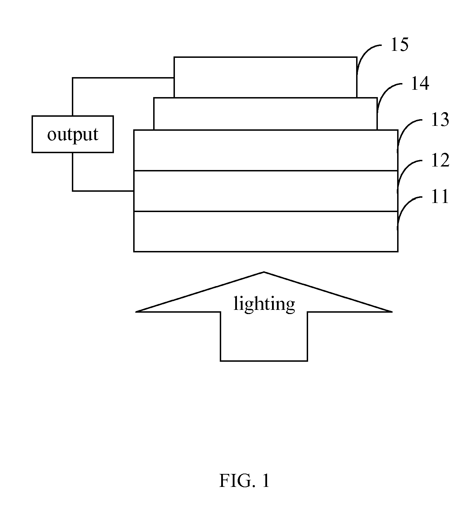

The structure of an organic solar cell device using the organic semiconductor materials of the present invention as an activity layer was shown in the FIG. 1.

The structure of the organic solar cell device was described as follows: glass 11 /ITO layer 12 /PEDOT: PSS layer 13 /active layer 14/Al layer 15; wherein the material of the active layer 14 included electron donor materials and electron acceptor materials; the electron donor materials was the organic semiconductor materials of the present invention, [6,6] - phenyl - C₆₁ - methyl butyrate (Abbreviation as PCBM) was used as electron acceptor materials, ITO was indium tin oxide with the sheet resistance of 10-20Ω/sq, PEDOT was poly(3, 4 - ethylenedioxy thiophene), PSS was poly(styrenesulfonate); the ITO glass was cleaned by ultrasonic cleaning and treated with an oxygen-Plasma, and then the ITO surface was spin-coated on the PEDOT: PSS, the organic semiconductor materials of the present invention was used as electron donor materials and PCBM was used as electron acceptor materials by spin coating technology, metal aluminum electrode was prepared by vacuum deposition techniques, and then the organic solar cell device was obtained. The thicknesses of ITO, PEDOT:PSS , active layer and Al layer are 110 nm, 40 nm, 110 nm and 110 nm, respectively.

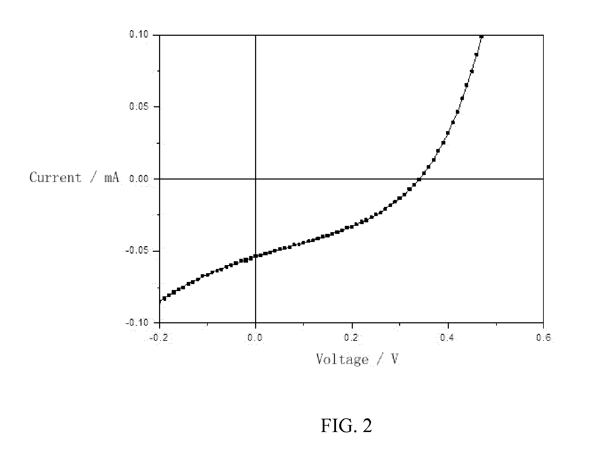

Taking the material of example 3 for example, the effective area of the prepared battery was 9 mm², the measurement was carried out in the sunlight simulator, the intensity of the light was verified by silicon standard battery, the I-V curve was measured by Keithley 2400. The IV curve of the device in the conditions of 100 milliwatts per square centimeter of the simulated lighting was shown in FIG. 2. The voltage of open circuit was 0.34 volts, the current of short-circuit was 0.053 mA, and the fill factor was 0.45, the efficiency of energy conversion is 0.091 %.

Example 6

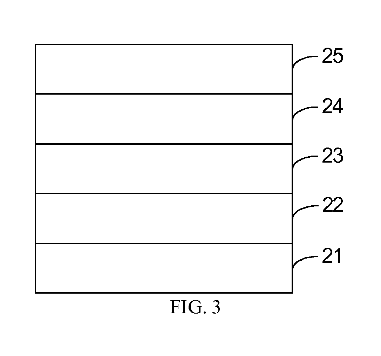

The structure of an organic electroluminescent device containing the organic semiconductor materials of the present invention was shown in FIG. 3.

The organic electroluminescent device had the following structure: an indium tin oxide (ITO) layer 22 with the sheet resistance of 10-20 Ω/sq was deposited on a glass substrate 21 as a transparent anode, a light-emitting layer 23 made of the organic semiconductor materials of the present invention was prepared on the ITO layer 22 by spin coating techniques, and then LiF was vacuum evaporated on the light-emitting layer 23 as buffer layer, final the metal Al layer 25 was deposited as the cathode of the device.

Example 7

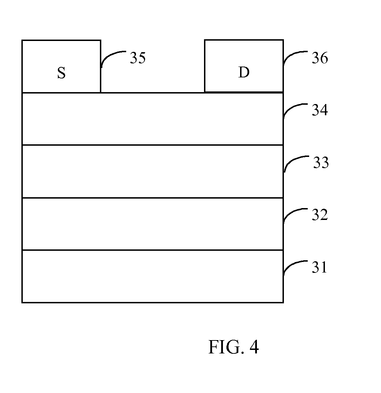

The structure of an organic field-effect transistor with the organic semiconductor materials of the present invention was shown in FIG. 4.

The organic field-effect transistor was described as follows: silicon (Si) was used as the substrate 31, SiO₂ with a thickness of 500 nm was used as insulating layer 32, the organic semiconductor material of the present invention was used as the organic semiconductor layer 34 and spin-coated on the layer of octadecyltrichlorosilane (OTS) 33 for modifying the SiO₂ layer 32, gold (other metal materials, aluminum, platinum, silver could also be used) was used as an electrode source electrode (S) 35 and the drain electrode (D) 36 was provided on the organic semiconductor layer 34.

It should be understood that the descriptions of the examples are specific and detailed, but those descriptions can't be used to limit the present disclosure. Therefore, the scope of protection of the invention patent should be subject to the appended claims.

## Claims

1. An organic semiconductor material represented by the following general formula (I): 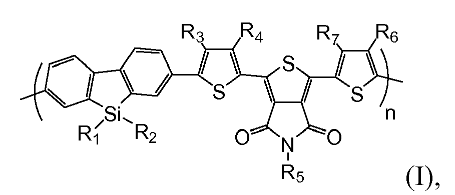 wherein R₁, R₂, R₃, R₄, R₅, R₆ and R₇ are C₁-C₂₀ alkyl; n is an integer greater than 1 and less than or equal to 100.

2. The organic semiconductor material according to claim 1, wherein R₁ and R₂ are identical C₁-C₂₀ alkyl; or R₃ and R₄ are identical C₁-C₂₀ alkyl; or R₆ and R₇ are identical C₁-C₂₀ alkyl.

3. The organic semiconductor material according to claim 1, wherein R₁, R₂, R₃, R₄, R₅, R₆, R₇ are identical C₁-C₂₀ alkyl; or R₁, R₂, R₃, R₄, R₅, R₆ and R₇ are C₁-C₂₀ alkyl different from each other.

4. The organic semiconductor material according to claim 1, wherein the n is an integer equal to or greater than 20 and less than or equal to 80.

5. A preparation method for the organic semiconductor material according to any one of claims 1 to 4, comprising the following steps:
S1, dissolving 2, 7 - dibromo-9, 9 - dialkyl silafluorene and n-butyl lithium in a first solvent at a temperature from -100°C to -25°C according to a molar ratio of 1:2.0 to 1.0:4.0, and then adding 2 - isopropoxy-4, 4, 5, 5 - tetramethyl-1, 3, 2 - dioxaborolane, reacting for 24 to 48 hours to obtain 2, 7 - bis (4, 4, 5, 5 - tetramethyl -1, 3, 2 - dioxaborolan-yl) - 9, 9 - dialkyl silafluorene;
S2, dissolving 1,3 - bis (3,4 - dialkyl thiophen-2 - yl)-5 - alkyl-4H-thiophen [3, 4-c] pyrrole -4,6 (5H) - diketone and a brominating agent in a second solvent at a temperature from 0°C to 30°C according to a molar ratio of 1:2 to 1:3, reacting for 12 to 48 hours to obtain 1,3 - bis (5 - bromo-3,4 - dialkyl thiophen-2 - yl)-5 - alkyl-4H-thiophen [3, 4-c] pyrrole -4,6 (5H) - diketone; and
S3, under an oxygen-free environment, adding the 2,7 - bis (4, 4, 5, 5 - tetramethyl-1, 3,2 - dioxaborolan-yl) - 9, 9 - dialkyl silafluorene prepared in the step S1 and the 1,3 - bis (5 - bromo-3,4 - dialkyl thiophen-2 - yl)-5 - alkyl-4H-thieno [3, 4-c] pyrrole -4,6 (5H) - diketone prepared in the step S2 in a third solvent containing catalyst and alkali solution according to a molar ratio of 1:a, then performing Suzuki reaction for 24 to 72 hours at a temperature from 65°C to 120°C to obtain the organic semiconductor material; wherein a is equal to or greater than 0.95 and less than or equal to 1.05.

6. The preparation method according to claim 5, wherein in the step S1, the first solvent is at least one selected from the group consisting of tetrahydrofuran, ether, dichloromethane, chloroform and ethyl acetate; a molar amount of the 2-isopropoxy-4, 4, 5, 5 - tetramethyl-1, 3, 2 - dioxaborolane is 2 to 4 times of a molar amount of the 2, 7 - dibromo-9, 9 - dialkyl silafluorene.

7. The preparation method according to claim 5, wherein in the step S2, the brominating agent is N-bromosuccinimide; the second solvent is at least one selected from the group consisting N, N-dimethyl formamide, tetrahydrofuran, ether, dichloromethane, chloroform, ethyl acetate and acetic acid.

8. The preparation method according to claim 5, wherein in the step S3, the third solvent is at least one selected from the group consisting tetrahydrofuran, toluene, chloroform, and ethyl acetate;
the catalyst is organic palladium or a mixture of organic palladium and organophosphine ligand, a molar amount of the catalyst is 0.0005 to 0.1 times of a molar amount of the 2, 7 - bis (4, 4, 5, 5 - tetramethyl-1, 3, 2 - dioxaborolan -yl) - 9, 9 - dialkyl silafluorene;
the alkali solution is at least one selected from the group consisting NaOH aqueous solution, Na₂CO₃ aqueous solution, NaHCO₃ aqueous solution and tetraethyl ammonium hydroxide aqueous solution, a molar amount of the alkali in the alkaline solution is 2 to 20 times of a molar amount of the 2, 7 - bis (4, 4, 5, 5 - tetramethyl-1, 3, 2 - dioxaborolan -yl) - 9, 9 - dialkyl silafluorene.

9. The preparation method according to claim 8, wherein the organic palladium is at least one selected from the group consisting Pd(PPh₃)₄, Pd₂(dba)₃ and Pd(PPh₃)₂Cl₂; and the organophosphine ligand is P(*o*-Tol)₃.

10. Uses of the organic semiconductor material according to any one of claims 1 to 4 in fields of organic solar cells, organic field-effect transistors, organic electroluminescent devices, organic optical memories, organic non-linear devices or organic laser devices, etc..
